# EUROPÄISCHE PATENTANMELDUNG

(11) **EP 1 569 003 A1**
(43) Veröffentlichungstag der Anmeldung: **31.08.2005**
(21) Anmeldenummer: 05004327.2
(22) Anmeldetag: 28.02.2005
(51) Int. Cl.: G01R 15/12, G01R 13/00, G01R 1/20, H01R 13/64, H01R 13/66, H01R 13/717

(54) **Messgerät**

(30) Priorität: 26.02.2004 DE 202004003164 U
(71) Anmelder: Hameg GmbH, 63533 Mainhausen (DE)
(72) Erfinder: Roth, Manuel, 63533 Mainhausen (DE)
(74) Vertreter: Thürer, Andreas

(57) **Zusammenfassung**

Um ein Messgerät mit mehreren Anschlussbuchsen (1) so auszubilden, dass eine zuverlässige und einfache Vorrichtung zur Unterstützung eines korrekten Steckens von Anschlusskabeln bereitgestellt wird, wird vorgeschlagen, dass insbesondere bei Messbuchsen mit mehreren Messmodi, von denen sich zumindest zwei Messmodi hinsichtlich der Belegung der Anschlussbuchsen (1) unterscheiden in zumindest einem Messmodus die aktive Belegung zumindest einer Anschlussbuchse (1) an dieser Anschlussbuchse (1) optisch zu signalisieren.

## Beschreibung

Die Erfindung betrifft ein Messgerät mit mehreren Anschlussbuchsen, insbesondere Messbuchsen, mit mehreren Messmodi, von denen sich zumindest zwei Messmodi hinsichtlich der Belegung der Anschlussbuchsen unterscheiden.

Bekannt sind Messbuchsen, die durch mechanische Verschlusseinrichtungen in unterschiedlichen Messmodi verschlossen werden können, um zu verhindern, dass falsche Anschlüsse eingerichtet werden. Dies ist insbesondere im Lehrbetrieb oder bei Einführung von neuen Messgeräten hilfreich.

Nachteilig ist, dass die Verschlusseinrichtungen aufwendig herzustellen und zu installieren sind. Falls die mechanische Sperre zu leicht zu überwinden ist, kommen Fehlanschlüsse gehäuft vor und stellen ein erhöhtes Sicherheits- und Funktionsrisiko dar.

Aufgabe der vorliegenden Erfindung ist es, ein Messgerät bereitzustellen, dass eine zuverlässige und einfache Vorrichtung zur Unterstützung eines korrekten Steckens von Anschlusskabeln ermöglicht.

Die Aufgabe wird gelöst durch ein Messgerät mit mehreren Anschlussbuchsen, insbesondere Messbuchsen, mit mehreren Messmodi, von denen sich zumindest zwei Messmodi hinsichtlich der Belegung der Anschlussbuchsen unterscheiden, wobei in zumindest einem Messmodus die aktive Belegung zumindest einer Anschlussbuchse an dieser Anschlussbuchse optisch zu signalisieren ist.

Das Messgerät weist verschiedene Messbuchsen auf, die je nach Messmodus unterschiedlich belegt werden. Bei einem Messgerät können mehrere Messbuchsen vorhanden sein, wobei nicht immer alle in einem bestimmten Messmodus für eine Messung benötigt werden. Damit der Benutzer direkt sieht, welche Anschlussbuchsen benötigt werden, werden die Anschlussbuchsen, die in einem Messmodus belegt werden müssen, optisch signalisiert, was insbesondere direkt beim Einschalten oder Umschalten auf einen anderen Messmodus vorgesehen ist.

Vorteilhaft ist es, wenn zumindest ein die aktive Belegung signalisierendes Leuchtmittel, insbesondere eine oder mehrere Glühbime(n) und/oder Leuchtdiode(n), vorgesehen ist, Hierdurch ist ein variabel an die Messbedingungen angepasster Hinweis auf die für einen Messmodus notwendig vorzunehmenden Kabelanschlüsse möglich. Die Leuchtmittet können mittels einer einfachen Schaltung angesteuert und schnell aktiviert und wieder deaktiviert werden. Auch bei einem eventuellen Ausfall eines Leuchtmittels ist weiterhin ein richtiges Anschließen möglich, da die Anschlussbuchse nicht versperrt ist. Eine Signalisierung ist auch bei schlechter Sicht, Dunkelheit oder in komplexeren Anlagen möglich.

Eine einfache Information über die Anschlussfunktionen der Anschlussbuchsen ist möglich, wenn eine Anschlussbuchse ein Kennzeichnungsmittel zur Kennzeichnung ihrer Anschlussfunktion aufweist, insbesondere eine farbliche Kennzeichnung und/oder einen Kennzeichnungsaufdruck, insbesondere in Form einer Beschriftung und/oder eines Symbols, wobei das Leuchtmittel der Anschlussbucllse das Kennzeichnungsmittel mit beleuchtet. Durch die Beleuchtung im Bereich der Anschlussbuchse wird eine Kennzeichnung gut erkennbar oder lesbar auch bei schlechter Umgebungsbeleuchtung. Hierdurch wird eine weitere Information neben der Anschlussbeleuchtung zur einfacheren Erkenn- und Unterscheidbarkeit der Anschlussfunktionen gegeben, beispielsweise ein Massesymbol oder Anschlussfarbe rot für positive Polarität bzw. einen Hinweis auf einen spannungsführenden Anschluss.

Eine sehr einfache und zugleich zuverlässige Vorrichtung liegt vor, wenn lediglich ein Leuchtmittel je Anschlussbuchse im Bereich der zugehörigen Anschlussbuchse angeordnet ist. Hierdurch ist zudem die Ansteuerung vereinfacht.

Eine erhöhte Aufmerksamkeit wird erreicht, wenn eine Anschlussbuchse von mehreren, zugehörigen Leuchtmitteln, vorzugsweise ringförmig, umgeben ist, welche gemeinsam die aktive Belegung signalisieren. Zudem kann hierdurch beispielsweise bei unterschiedlichen Leuchtmittelanzahlen an verschiedenen Anschlussbuchsen eine Steckreihenfolge vorgegeben werden oder weitere Hinweise zum Anschluss der Kabel. Darüber hinaus ist eine erhöhte Sicherheit durch eine stärkere Beleuchtung gegeben, die auch noch aktiviert werden kann, wenn ein Teil der Leuchtmittel ausfällt.

Eine deutlich sichtbare, weitreichende Signalisierung liegt vor, wenn ein Leuchtmittel eine im wesentlichen einem stumpfen (Raum-) Winkel bis allseitiger Abstrahlung entsprechende Abstrahlcharakteristik aufweist und/oder ein Streumittel vorgesehen ist, welches eine diffuse Abstrahlung erzeugt.

Einen Hinweis auf ein für ein Anschlusskabel vorgesehene Anschlussbuchse ist insbesondere gegeben, wenn eine ringförmige Anordnung von Leuchtmitteln vorgesehen ist, welche durch eine zumindest teilweise diffus transparente und/oder farbige Kunststoffhülse zumindest abschnittsweise abgedeckt ist. Durch die ringfömige Anordnung der Leuchtmittel wird der Zweck der Anschlussbuchse zum Anschluss des Kabel hervorgehoben. Da die Leuchtmittel durch eine Kunststoffhülse hindurch leuchten, sind sie vor Beschädigungen im Steckvorgang oder beim Herausziehen geschützt. Ein beleuchteter Ring tritt somit in einer Doppelfunktion als Diffusor und zur Gewährleistung einer Schutzvorrichtung auf.

Eine zuverlässige Signalgebung ist auch bei chemischen oder physikalischen belastenden Umgebungseinflüssen gegeben, wenn zumindest ein Leuchtmittel innerhalb eines Gehäuses des Messgerätes angeordnet ist, dessen Licht über eine Lichtleitvorrichtung aus dem Gehäuse nach außen an die zugehörige Anschlussbuchse geleitet ist.

Eine belastbare Verbindung der Lichtleitvorrichtung mit der Anschlussbuchse ist gewährleistet, wenn die Lichtleitvorrichtung in ein mechanisches Verbindungsstück und/oder einen mechanischen Verbindungsabschnitt der zugehörigen Anschlussbuchse mit dem Gehäuse integriert ist. Die Anschlussbuchse kann in wenigen Fertigungsschritten in das Messgerät integriert werden. Darüber hinaus ist eine im wesentlichen fluchtende Anordnung von Leuchtmittel und Lichtaustritt an der Anschlussbuchse gegeben. Hierdurch wird die Signalwirkung verstärkt und es ist auch eine sehr dichte Anordnung von Anschlussbuchsen mögiich.

Eine vereinfachte Herstellung des Messgeräts ist möglich, wenn das Leuchtmittel auf einer Leuchtmittelplatine aufgebracht ist, über welche die Stromversorgung und Ansteuerung des Leuchtmittels erfolgt, wobei insbesondere die Leuchtmittelplatine zwischen einer Anschlussbuchsen-Platine und der Gehäusewandung angeordnet ist und von einem Innenabschnitt der Anschlussbuchse in einer Durchgriffsausnehmung durchgriffen ist. Die Leuchtmittel verschiedenen Anschlussbuchsen können somit zuverlässig angesteuert werden und es sind auch komplexere Schaltungen möglich. Die Leuchtmittelstromversorgung und Ansteuerung ist von der Stromversorgung des Messgeräts einfach zu trennen und kann gesondert aktiviert werden, wodurch sich auch Störungen des Messablaufs nicht auf die Beleuchtungssignale auswirken.

Ein zuverlässige Aktivierung der Hinweise auf die notwendige Anschlussbuchsenbelegung ist gewährleistet, wenn die optische Signalisierung abhängig von der Wahl eines Messmodus durch eine Steuerung, insbesondere einen Mikrocontroller oder Mikroprozessor des Messgerätes, automatisch erfolgt.

Vorteilhaft ist es, wenn zusätzlich eine mechanische Verschlussvorrichtung vorgesehen ist, welche, vorzugsweise automatisch nach Maßgabe einer Steuerung abhängig von dem gewählten Messmodus, aktive Anschlussbuchsen freigibt und/oder nicht aktive Anschlussbuchsen versperrt. Hierdurch kann auch ein Tasten zu einer lnformation über den Anschlussvorgang führen, beispielsweise auch in unzugänglichen Bereichen oder für Sehbehinderte Bediener.

Eine hilfreiche Einschränkung der Auswahl der Anschlussbuchsen ist gegeben, wenn in jedem Messmodus alle in diesem Messmodus verwendeten Anschlussbuchsen als aktive Anschlussbuchsen optisch signalisiert sind. In diesem Fall muss der Bediener lediglich die beleuchteten Anschlussbuchsen verkabeln und eine Fehlbelegung ist nahezu ausgeschlossen.

Auch komplexere Steckvorschriften können durch die vorgeschlagene Erfindung leicht signalisiert werden, dies ist insbesondere gegeben, wenn das Messgerät ein Oszillograph oder ein Multimeter, insbesondere ein Digital-Oszillograph bzw. ein Digital-Multimeter, ist.

Weitere Merkmale und Vorteile der Erfindung ergeben sich aus den Ansprüchen und der nachstehenden Beschreibung, in der Ausführungsbeispiele des Gegenstands der Erfindung in Verbindung mit den Zeichnungen näher erläutert sind.

Es zeigen:
- Fig. 1: eine schematische Schnittansicht eines Ausschnitts eines Messgeräts und
- Fig. 2: eine schematische Aufsicht auf zwei Anschlussbuchsen.

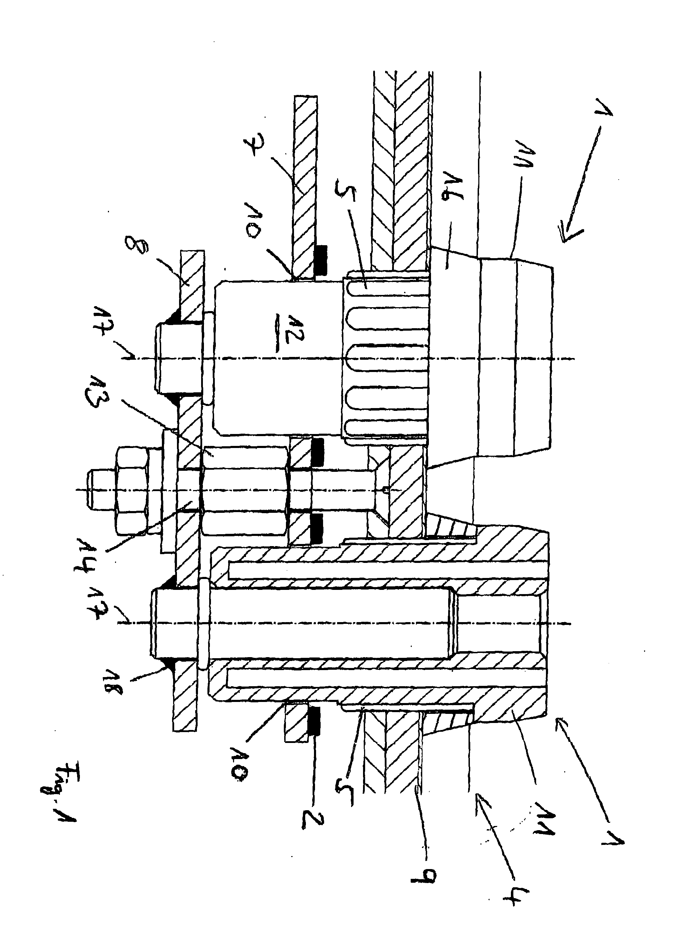

Fig. 1 zeigt eine schematische Schnittansicht eines Ausschnitts eines Messgeräts. Das Messgerät weist zwei Anschlussbuchsen 1 für den Anschluss von Kabeln an das Messgerät insbesondere zur Herstellung einer Messverbindung auf. Die Anschlussbuchsen 1 sind in Ausnehmungen 15 in einer Gehäusewandung 9 des Gehäuses 4 des Messgeräts eingesetzt und durch umlaufende Auskragungen 16 einer tragenden Kunststoffhülse 11 gehalten. Die Anschlussbuchsen 1 erstrecken sich in ihrer Längsachse 17 durch jeweils eine Durchgriffsausnehmung 10 und eine Ausnehmung 18 in zwei parallel zum Gehäuse 4 von einem Befestigungselement 14 mit einem Abstandsstück 13 gehaltenen Platinen. Durch eine Anschlussbuchsen-Platine 8 wird eine elektrisch leitende Verbindung, insbesondere eine Lötverbindung 19, für die in den Anschlussbuchsen 1 eingesteckten Kabel mit dem Messgerät gewährleistet.

Eine mittig zwischen dem Gehäuse 4 und der Anschlussbuchsen-Platine 8 angeordnete Leuchtmittelplatine 7 weist nahe an den Anschlussbuchsenausnehmungen 10 Leuchtmittel 2, insbesondere LEDs, auf. Das Licht der Leuchtmittel 2 wird durch eine ringförmig um einen Innenabschnitt 12 der Anschlussbuchse 1 angeordnete zylindrische Lichtleitvorrichtung 5 geschützt durch die Kunststoffhülse 11 an die Außenseite des Gehäuses 4 geleitet. Die Lichtleitvorrichtung 5 kann aus durchsichtigem, eventuell farbigem Kunststoff bestehen.

Das Licht der Leuchtmittel 2 wird somit durch die Lichtleitvorrichtung 5 für einen Benutzer des Messgeräts als Anschlusshilfe für die in einem jeweiligen Messmodus notwendigen Kabel sichtbar. Zugleich ist das Leuchtmittel 2 sicher und geschützt in dem Messgerät untergebracht. Die Ansteuerung des Leuchtmittels 2 erfolgt über die Leuchtmittelplatine 7. Je nach Messmodus wird eine andere Anschlussbuchse 1 angesteuert.

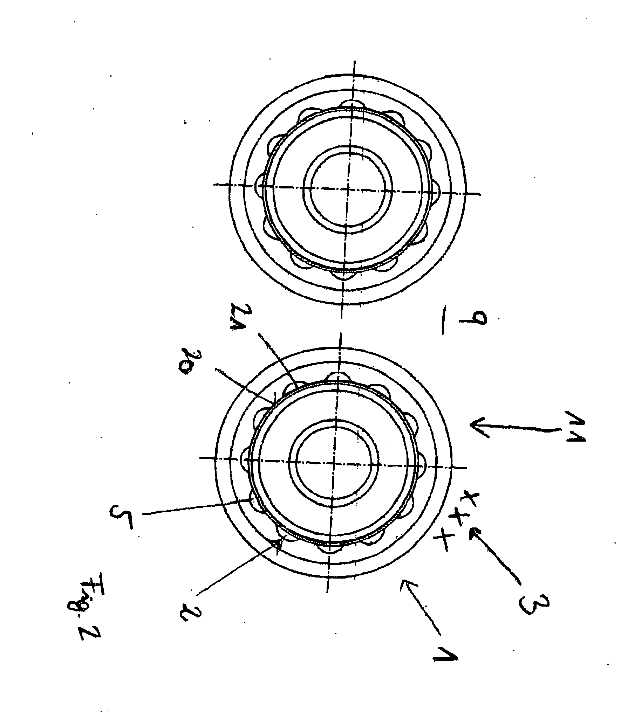

Fig. 2 zeigt eine schematische Aufsicht auf zwei Anschlussbuchsen 1, die in einer Gehäusewandung 9 angeordnet sind. Die Anschlussbuchsen 1 weisen eine zylinderförmige Kunststoffhülse 11, mit mehreren ineinander angeordneten zylinderförmigen Abschnitten auf. Die Lichtleitvorrichtung 5 ist am Außenumfang der Außenseite 20 eines der Zylinder angebracht. Die Lichtleitvorrichtung 5 weist mehrere Lichtleitkanäle 21 auf, die insbesondere aus durchsichtigem Kunststoff bestehen.

Die Lichtleitvorrichtung 5 leitet das Licht der LEDs innerhalb des Gehäuses an die Oberseite und ermöglicht somit beispielsweise auch eine Beleuchtung eines Kennzeichnungsmittels 3 an der Gehäusewandung 9 neben einer Anschlussbuchse 1.

### BEZUGSZEICHENLISTE

- 1: Anschlussbuchse
- 2: Leuchtmittel
- 3: Kennzeichnungsmittel
- 4: Gehäuse
- 5: Lichtleitvorrichtung
- 6: Verbindungsabschnitt
- 7: Leuchtmittelplatine
- 8: Anschlussbuchsen-Platine
- 9: Gehäusewandung
- 10: Durchgriffsausnehmung
- 11: Kunststoffhülse
- 12: Innenabschnitt
- 13: Abstandsstück
- 14: Befestigungselement
- 15: Ausnehmung
- 16: Auskragung
- 17: Längsachse
- 18: Ausnehmung
- 19: Lötverbindung
- 20: Außenseite
- 21: Lichtleitkanäle

## Patentansprüche

1. Messgerät mit mehreren Anschlussbuchsen (1), insbesondere Messbuchsen, mit mehreren Messmodi, von denen sich zumindest zwei Messmodi hinsichtlich der Belegung der Anschlussbuchsen (1) unterscheiden, wobei in zumindest einem Messmodus die aktive Belegung zumindest einer Anschlussbuchse (1) an dieser Anschlussbuchse (1) optisch zu signalisieren ist.

2. Messgerät nach Anspruch 1, **dadurch gekennzeichnet, dass** zumindest.ein die aktive Belegung signalisierendes Leuchtmittel (2), insbesondere eine oder mehrere Glühbirne(n) und/oder Leuchtdiode(n), vorgesehen ist.

3. Messgerät nach Anspruch 2, **dadurch gekennzeichnet, dass** eine Anschlussbuchse (1) ein Kennzeichnungsmittel (3) zur Kennzeichnung ihrer Anschlussfunküon aufweist, insbesondere eine farbliche Kennzeichnung und/oder einen Kennzeichnungsaufdruck, Insbesondere in Form einer Beschriftung und/oder eines Symbols, wobei das Leuchtmittel (2) der Anschlussbuchse (1) das Kennzeichnungsmittel (3) mit beleuchtet.

4. Messgerät nach Anspruch 2 oder 3, **dadurch gekennzeichnet, dass** lediglich ein Leuchtmittel (2) je Anschlussbuchse (1) im Bereich der zugehörigen Anschlussbuchse (1) angeordnet ist.

5. Messgerät nach Anspruch 2 oder 3, **dadurch gekennzeichnet, dass** eine Anschlussbuchse (1) von mehreren, zugehörigen Leuchtmitteln (2), vorzugsweise ringförmig, umgeben ist, welche gemeinsam die aktive Belegung signalisieren.

6. Messgerät nach einem der Ansprüche 2 bis 5, **dadurch gekennzeichnet, dass** ein Leuchtmittel (2) eine im wesentlichen einem stumpfen (Raum-) Winkel bis allseitiger Abstrahlung entsprechende Abstrahlcharakteristik aufweist und/oder ein Streumittef vorgesehen ist, welches eine diffuse Abstrahlung erzeugt.

7. Messgerät nach Anspruch 5 und 6, **dadurch gekennzeichnet, dass** eine ringförmige Anordnung von Leuchtmitteln (2) vorgesehen ist, welche durch eine zumindest teilweise diffus transparente und/oder farbige Kunststoffhülse (11) zumindest abschnittsweise abgedeckt ist.

8. Messgerät nach einem der Ansprüche 2 bis 7, **dadurch gekennzeichnet, dass** zumindest ein Leuchtmittel (2) innerhalb eines Gehäuses (4) des Messgerätes angeordnet ist, dessen Licht über eine Lichtleitvorrichtung (5) aus dem Gehäuse (4) nach außen an die zugehörige Anschlussbuchse (1) geleitet ist.

9. Messgerät nach Anspruch 8, **dadurch gekennzeichnet, dass** die Lichtleitvorrichtung (5) in ein mechanisches Verbindungsstück und/oder einen mechanischen Verbindungsabschnitt (6) der zugehörigen Anschlussbuchse (1) mit dem Gehäuse (4) integriert ist.

10. Messgerät nach Anspruch 8 oder 9, **dadurch gekennzeichnet, dass** das Leuchtmittel (2) auf einer Leuchtmittelplatine (7) aufgebracht ist, über welche die Stromversorgung und Ansteuerung des Leuchtmittels (2) erfolgt, wobei insbesondere die Leuchtmittelplatine (7) zwischen einer Anschlussbuchsen-Platine (8) und der Gehäusewandung (9) angeordnet ist und von einem Innenabschnitt (12) der Anschlussbuchse (1) in einer Durchgriffsausnehmung (10) durchgriffen ist.

11. Messgerät nach einem der Ansprüche 1 bis 10, **dadurch gekennzeichnet, dass** die optische Signalisierung abhängig von der Wahl eines Messmodus durch eine Steuerung, insbesondere einen Mikrocontroller oder Mikroprozessor des Messgerätes, automatisch erfolgt.

12. Messgerät nach einem der Ansprüche 1 bis 11, **dadurch gekennzeichnet, dass** zusätzlich eine mechanische Verschlussvorrichtung vorgesehen ist, welche, vorzugsweise automatisch nach Maßgabe einer Steuerung abhängig von dem gewählten Messmodus, aktive Anschlussbuchsen (1) freigibt und/oder nicht aktive Anschlussbuchsen (1) versperrt.

13. Messgerät nach einem der Ansprüche 1 bis 12, **dadurch gekennzeichnet, dass** in jedem Messmodus alle in diesem Messmodus verwendeten Anschlussbuchsen (1) als aktive Anschlussbuchsen (1) optisch signalisiert sind.

14. Messgerät nach einem der Ansprüche 1 bis 13, **dadurch gekennzeichnet, dass** das Messgerät ein Oszilloskop oder ein Multimeter, insbesondere ein Digital-Oszilloskop bzw. ein Digital-Multimeter, ist.
